Europäisches Patentamt

European Patent Office

Office européen des brevets

(19)

(11) Numéro de publication: **0 006 785**

**B1**

## (12) FASCICULE DE BREVET EUROPEEN

(45) Date de publication du fascicule du brevet: **27.01.82**

(21) Numéro de dépôt: **79400366.5**

(22) Date de dépôt: **06.06.79**

(51) Int. Cl.³: **H 02 H 7/20,**
**H 02 M 5/257, G 05 F 1/44**

(54) **Dispositif de chauffage de cathode pour tube électronique de puissance, et émetteur comportant un tel dispositif.**

(30) Priorité: **13.06.78 FR 7817620**

(43) Date de publication de la demande:
**09.01.80 Bulletin 80/1**

(45) Mention de la délivrance du brevet:
**27.01.82 Bulletin 82/4**

(84) Etats contractants désignés:
**CH DE GB NL**

(56) Documents cités:
**CH - A - 496 809**
**FR - A - 1 388 674**

**ELECTRONIC ENGINEERING, vol. 46, no 558, août 1974, Londres (GB)**
**"Semiconductor processes and products in the melt", pages 25—28.**

(73) Titulaire: **THOMSON-CSF**
**173, Boulevard Haussmann**
**F-75360 Paris Cedex 08 (FR)**

(72) Inventeur: **Lecornet, Jean-Claude "THOMSON-CSF" - SCPI**
**173, bld Haussmann**
**F-75360 Paris Cedex 08 (FR)**

(74) Mandataire: **Courtellemont, Alain et al,**
**"THOMSON-CSF" - SCPI 173, bld Haussmann**
**F-75360 Paris Cedex 08 (FR)**

Courier Press, Leamington Spa, England.

## Dispositif de chauffage de cathode pour tube électronique de puissance, et émetteur comportant un tel dispositif.

La présente invention se rapporte à un dispositif de chauffage de cathode pour tube électronique de puissance, comportant des moyens de commande de l'alimentation en courant de chauffage de la cathode pour commander une augmentation prédéterminée de ce courant jusqu'à une valeur $I_o$ pour un préchauffage du tube puis, pour un fonctionnement normal du tube, jusqu'à une valeur $I_m$ ($I_m$ : valeur efficace du courant de chauffage lorsque la cathode a atteint sa température pour un fonctionnement normal du tube; $I_o$ : valeur efficace de courant, inférieure à $I_m$).

La présente invention se rapporte également aux émetteurs comportant un tel dispositif de chauffage de cathode.

Le fonctionnement normal dont il vient d'être question est le fonctionnement du tube à la valeur nominale de la tension de chauffage en régime d'exploitation, telle que définie dans les caractéristiques du constructeur du tube.

De tels dispositifs sont connus dans lesquels le courant de chauffage de la cathode n'est pas porté immédiatement à sa valeur maximale correspondant à un fonctionnement normal du tube en régime établi. Dans les dispositifs connus le courant de chauffage de la cathode est augmenté par paliers grâce à des résistances qui sont progressivement court-circuitées à mesure que la température de la cathode augmente. Ceci évite que la cathode se déforme et puisse venir en contact avec d'autres électrodes, provoquant la mise hors d'usage du tube. Par contre cette mise en service par paliers nécessite des dispositifs électro-mécaniques lourds, encombrants, et pouvant amener des risques de pannes; du fait de leur encombrement ces dispositifs électro-mécaniques sont difficiles à mettre en oeuvre s'ils n'ont pas été prévus au moment de la réalisation du matériel mais résultent d'exigences nouvelles dues, par exemple, à l'expérience donnée par l'exploitation. De plus, au moment des changements de paliers, il se produit une pointe de courant de chauffage qui, pour rester inférieure à la valeur à ne pas dépasser telle qu'elle apparaît dans les notices des tubes, nécessite soit, l'utilisation de transformateurs de chauffage à fuite soit un nombre minimum donné de paliers.

Le but de la présente invention est d'éviter le plus possible les inconvénients des dispositifs selon l'art connu.

Selon l'invention, il est possible d'atteindre ce but avec un dispositif tel qu'il est décrit, en particulier, dans la revendication 1 ci-jointe.

Il est à noter que la présente invention est obtenue par une association de moyens connus en eux-mêmes; c'est ainsi que des circuits interrupteurs pour couper l'alimentation et des moyens de commande pour commander les coupures à une fréquence donnée (généralement la fréquence de la tension d'alimentation) en fonction de la valeur d'un signal de commande, sont connus, en particulier par l'article d'ELECTRONIC ENGINEERING vol. 46, n° 558, août 1974, Londres (GB) "Semiconductor process and products in the melt" pages 25—28, par le brevet français n° 1 388 674 et par le brevet suisse n° 496809.

L'article de ELECTRONIC ENGINEERING décrit un dispositif d'asservissement et plus précisément de régulation, dans lequel l'élément de référence peut être un thermistor mais, si l'ouverture d'un circuit interrupteur est commandée à une fréquence donnée, par contre cette ouverture n'est pas fonction du temps qui s'écoule, c'est en effet une fonction de la valeur donnée par l'élément de référence.

Le brevet français n° 1 388 674 concerne un asservissement qui permet de régler à une valeur donnée la puissance fournie à un appareil, sans variation prédéterminée avec le temps.

Le brevet suisse n° 496 809 montre un asservissement de la puissance de chauffage d'une installation de chauffage de fil ou de bande en fonction de la vitesse de défilement du fil ou de la bande, donnée par un tachymètre.

Il est à remarquer, au sujet des trois textes ci-avant mentionnés, qu'ils ne peuvent être utilisé comme dispositifs de chauffage de cathode pour tube électronique de puissance étant donné qu'il est nécessaire que la variation du courant de chauffage de cathode ne soit pas asservie mais commandée en fonction du temps écoulé.

La présente invention sera mieux comprise à l'aide de la description ci-après et des figures s'y rapportant qui représentent:

—la figure 1 un dispositif selon l'invention;

—les figures 2 et 3 des diagrammes relatifs à des signaux du dispositif selon la figure 1.

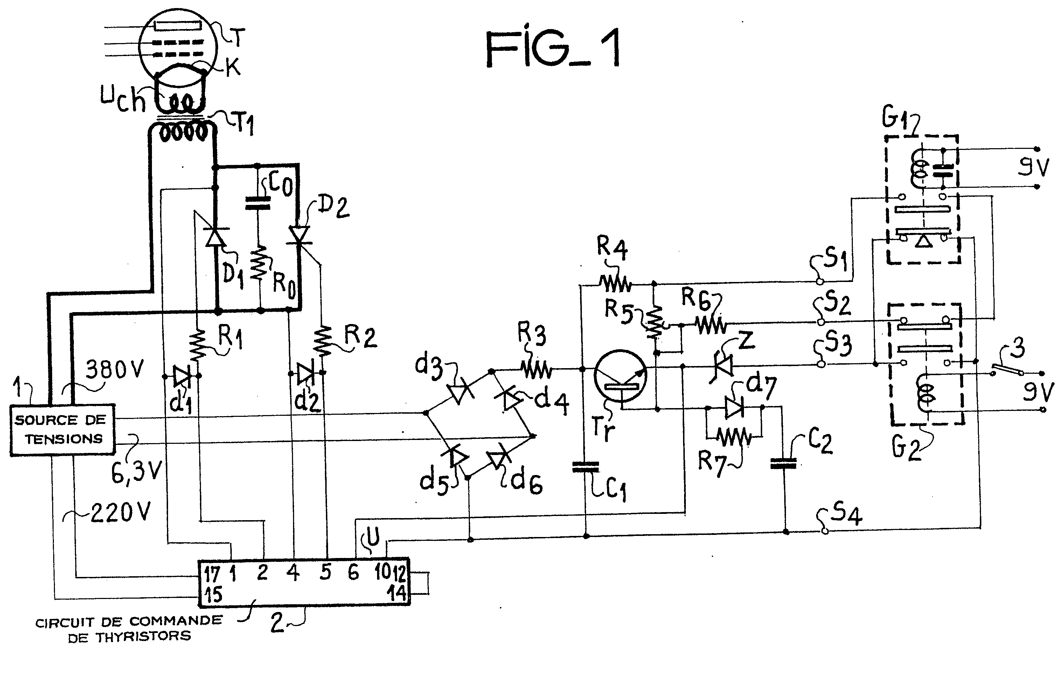

La figure 1 représente un dispositif de chauffage de la cathode, K, d'une tétrode de puissance, T, de 300 kW de puissance efficace de la porteuse H. F., fabriquée par la société THOMSON—CSF sous la référence TH 537. Le chauffage est un chauffage direct. L'énergie du chauffage est fournie à la cathode K à travers un transformateur $T_1$; cette énergie provient d'une source de tensions alternatives, 1. La source de tensions 1 fournit en permanence trois tensions différentes, de valeurs efficaces 380 V, 220 V et 6,3 V, à la même fréquence, F, de 50 Hz.

Sur la figure 1 le circuit de puissance qui fait la liaison entre les sorties de la tension de 380 V de la source de tensions 1 et la cathode K a été dessiné en traits forts. Le circuit de puissance commporte, outre le transformateur $T_1$, un dispositif interrupteur disposé entre l'une des deux bornes de sortie de la tension de 380 V et l'une des bornes du primaire du transformateur

$T_1$; le dispositif interrupteur est constitué par deux thyristors $D_1$, $D_2$ montés téte-bêche et en parallèle. Entre les anodes et les cathodes des thyristors $D_1$, $D_2$ est monté en parallèle un ensemble série constitué d'une résistance $R_o$ et d'un condensateur $C_o$.

La commande des thyristors $D_1$, $D_2$ est effectuée à l'aide d'un circuit de commande de thyristors 2 (circuit de commande de thyristors référence $L_1$, de la société SILEC); à cet effet les bornes 1, 2, 4 et 5 du circuit 2 sont respectivement reliées

—à l'anode d'une diode $d_1$ et à la cathode du thyristor $D_1$;

—à la cathode de la diode $d_1$ et, à travers une résistance $R_1$, à l'électrode de commande du thyristor $D_1$,

—à l'anode d'une diode $d_2$ et à la cathode du thyristor $D_2$,

—à la cathode de la diode $d_2$ et, à travers une résistance $R_2$, à l'électrode de commande du thyristor $D_2$.

Le circuit de commande 2 reçoit, entre ses bornes 6 et 10, une tension de commande U dont l'obtention sera décrite plus loin et, entre ses bornes 15 et 17, une tension de synchronisation qui est la tension de 220 V délivrée par la source de tensions 1; d'autre part les bornes 12 et 14 du circuit de commande de thyristors 2, sont court-circuitées.

L'angle d'ouverture des thyristors $D_1$ et $D_2$, et donc le courant efficace de chauffage du tube T, est commandé par les signaux de déblocage que délivre, respectivement entre ses bornes 1—2 et 4—5, le circuit 2. Ces signaux de déblocage sont des trains d'impulsions constitués d'impulsions de 13 $\mu$S, de 5 V d'amplitude et distantes de 150 $\mu$S. Les trains d'impulsions se succèdent à la fréquence du courant alternatif fourni par la source de tensions 1, c'est-à-dire à la fréquence F de 50 Hz. La durée des trains d'impulsions est fonction linéaire de l'amplitude de la tension de commande, U, appliquée entre les bornes 6 et 10 du circuit de commande de thyristors, 2.

Les dispositif de chauffage selon la figure 1 est destiné

—à permettre un échauffement progressif du tube T lors de l'allumage; cet échauffement devant se faire de manière continue, c'est-à-dire sans les paliers de certains dispositifs selon l'art connu où des résistances, en série dans le circuit de puissance qui amène le courant à la cathode, sont court-circuitées les unes après les autres à mesure que la température de la cathode s'élève; cet échauffement progressif devant, de plus, avoir une variation dans le temps adaptée au tube à échauffer, c'est-à-dire que, pendant l'échauffement dû au courant de chauffage fourni à la cathode, il ne doit pas risquer d'endommager ce dernier,

—à fournir un courant de chauffage de la cathode assurant un "préchauffage" de la cathode; ce "préchauffage" donnant la possibilité, en cas d'arrêt entre deux utilisations du tube, de redémarrer rapidement une utilisation normale du tube et, éventuellement (si la tension de préchauffage est suffisamment faible), dannant la possibilité d'arrêter les systèmes de refroidissement du tube,

—à permettre de redémarrer très rapidement une utilisation normale du tube en cas d'arrêt accidentel de faible durée de la tension d'alimentation; dans le cas de l'exemple traité un tel fonctionnement est prévu pour des arrêts accidentels de moins de 5 secondes.

Ces résultats sont obtenus grâce au circuit de commande en tension qui va être décrit ci-après. Ce circuit fournit la tension de commande U au circuit de commande de thyristors, 2, qui règle la valeur moyenne du courant de chauffage de la cathode du tube.

Le circuit de commande en tension comporte un circuit redresseur à quatre diodes ($d_3$ à $d_6$) qui redresse les deux alternances de la tension de 6,3 V fournie par la source de tensions 1 et dont les bornes positive et négative de sortie sont respectivement reliées à la première extrémité d'une résistance $R_3$ de 100 ohms et à la borne 10 du circuit de commande de thyristors, 2.

La seconde borne de la résistance $R_3$ est reliée au collecteur d'un transistor NPN, $T_r$, à la première extrémité d'une résistance $R_4$ de 470 ohms et, à travers un condensateur $C_1$ de 1000 microfarads, à la borne 10 du circuit 2.

Le transistor $T_r$ joue le rôle de transistor ballast; il a son émetteur qui est relié à la borne 6 du circuit 2 et à la cathode d'une diode Zener Z de tension de Zener égale à 5,8 V, dont la cathode est reliée à la borne $S_3$ d'un ensemble de quatre bornes fictives ($S_1$ à $S_4$) représentées sur la figure 1 pour faciliter les explications. La base du transistor $T_r$ est reliée à la première extrémité d'une résistance variable $R_5$ de 10 000 ohms et au curseur de cette résistance; la seconde extrémité de la résistance variable $R_5$ est reliée à la seconde extrémité de la résistance $R_4$ et à la borne $S_1$. La base du transistor $T_r$ est également reliée à l'anode d'une diode $d_7$ dont la cathode est reliée, à travers un condensateur $C_2$ de 10 000 microfarads, à la borne 10 du circuit de commande de thyristors, 2. Une résistance $R_7$ de 470 ohms est branchée en parallèle sur la diode $d_7$.

Une résistance $R_6$ de 1000 ohms relie le curseur de la résistance $R_5$ à la borne $S_2$. La borne $S_4$ est directement reliée à la borne 10 du circuit de commande de thyristors, 2.

Deux relais $G_1$ et $G_2$ à deux contacts, sont représentés sur la figure 1 en position de repos. Le relais $G_1$ est un relais temporisé qui présente une constante de temps de 1 minute à la mise sous tension de sa bobine et de 5 secondes à la mise hors-tension de sa bobine; le relais $G_2$ est un relais non temporisé. La tension continue de 9 V fournie par le circuit redresseur $d_3$ à $d_6$ est appliquée directement aux bornes de la bobine du relais $G_1$ et, sous la commande d'un interrupteur 3, aux bornes de la bobine du relais $G_2$.

L'interrupteur 3 sert à choisir entre en chauffage de la cathode K pour un fonctionnement normal du tube T (position ouverte) et un régime de "préchauffage" tel qu'il a été défini ci-avant (position fermée); cette fonction de l'interrupteur 3 apparaîtra dans ce qui suit.

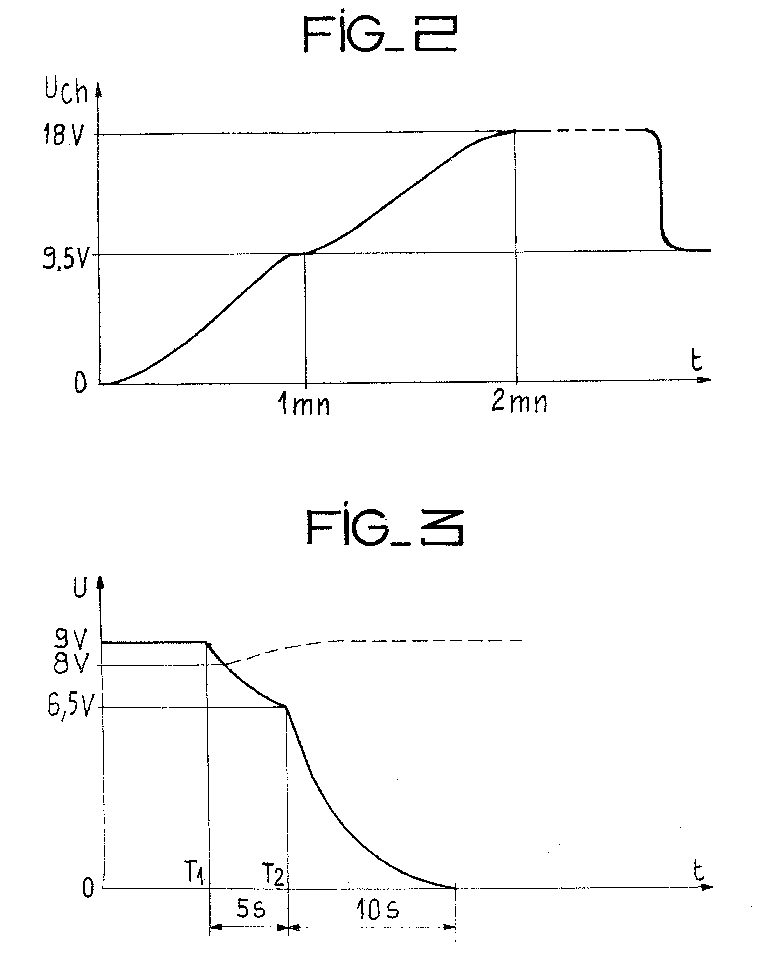

A partir du moment où la source de tensions 1 délivre ses tensions de sortie, et quelle que soit la position de l'interrupteur 3, les bornes $S_3$ et $S_4$ sont court-circuitées pendant 1 mn du fait de la temporisation de 1 mn à la mise sous tension du relais $G_1$; par contre il n'y a pas de court-circuit entre les bornes $S_1$ et $S_2$. Il en résulte que le condensateur $C_2$ se charge, à travers les résistances $R_3$, $R_4$, $R_5$, sensiblement jusqu'à la tension de Zener de la diode Zener Z; cette charge se fait avec une constante de temps sensiblement égale à $R_5 C_2$ étant donné que $R_3$ et $R_4$ sont négligeables devant $R_5$; ceci entraîne une croissance de la tension U appliquée entre les bornes 6 et 10 du circuit de commande de thyristors, 2, avec une constante de temps égale à $R_5 C_2$ de O à la tension de Zener (5,8 V) entre les temps $t = 0$ et $t = 1$ mn; il en résulte une croissance de la tension de chauffage $U_{ch}$ de la cathode du tube T qui a l'allure indiquée sur la figure 2 entre les temps $t = 0$ et $t = 1$ mn.

Au temps $t = 1$ mn, c'est-à-dire 1 minute après que la source 1 ait commencé à délivrer ses tensions de sortie, le relais $G_1$ se déclenche. Si l'interrupteur 3 est fermé, ce qui entraîne que le relais $G_2$ est en position de travail, le déclenchement de $G_1$ est sans effet sur la tension U qui reste égale à la tension de Zener de la diode Z.

Si, par contre, au temps $t = 1$ mn l'interrupteur 3 est ouvert et donc le relais $G_2$ en position de repos, le relais $G_1$ en se déclenchant coupe la liaison directe entre les bornes $S_3$ et $S_4$ et crée un court-circuit entre les bornes $S_1$ et $S_2$; la tension aux bornes du condensateur $C_2$ n'est plus alors limitée par la tension de Zener de la diode Z mais, à la chute de tension près dans le transistor $T_r$ et dans la diode $d_7$, croît jusqu'à la valeur de la tension continue fournie par le circuit redresseur composé des quatre diodes $d_3$ à $d_6$; la croissance de la tension U se fait alors avec une constante de temps sensiblement égale à $C_2 R_p$ où $R_p$ est la valeur de la résistance équivalente aux résistances $R_5$ et $R_6$ mises en parallèle du fait du court-circuit entre les bornes $S_1$ et $S_2$. Ceci entraîne une variation de la tension de chauffage, $U_{ch}$, qui a l'allure indiquée entre les temps $t = 1$ mn et $t = 2$ mn sur la figure 2: croissance de 9,5 à 18 V entre les temps $t = 1$ mn et $t = $ mn. Cette allure est fonction de la constante de temps $C_2 R_p$, à laquelle se rajoute une constante de temps introduite par le circuit 2, et de la relation non linéaire entre la valeur de U qui détermine l'angle d'ouverture des thyristors et la tension $U_{ch}$ qui en résulte; la courbe de la figure 2, qu'il serait difficile de déterminer par le calcul, a été relevée expérimentalement.

Les valeurs atteintes au bout des temps $t = 1$ mn et $t = 2$ mn par la tension U et donc par la tension $U_{ch}$ (figure 2) sont ajustables, il suffit pour cela de changer la diode Zener.

La tension U, comme il été indiqué plus avant, commande le chauffage de la cathode du tube T. Cette commande se fait en deux étapes à partir du moment où le dispositif selon la figure 1 est alimenté. Pendant la première étape (de $t = 0$ à $t = 1$ nm sur la figure 2) et avec une pente (fonction du produit $R_5 C_2$) et une tension de commande finale (ici 5,8 V déterminées par la diode Zener Z) choisies en fonction du tube et en particulier de la valeur efficace, $I_o$, du courant de "préchauffage" à atteindre, la tension de chauffage, $U_{ch}$, amène la cathode du tube T à une température de "préchauffage" de 800 à 1000°C avec une célérité maximale compte tenu des variations de température que peut supporter sans dommage cette cathode. Il est à noter que ce "préchauffage" a été choisi de manière à pouvoir arrêter les systèmes de refroidissement du tube.

Pendant la seconde étape (de $t = 1$ mn à $t = 2$ mn sur la figure 2) et avec pente donnée (fonction du produit $C_2 R_p$, c'est-à-dire de $C_2$, $R_5$ et $R_6$) et une tension de commande donnée (déterminée par la tension alternative fournie par la source de tensions au circuit redresseur $d_3$—$d_6$: environ 9 V dans le cas présent) la tension U entraîne une tension de chauffage $U_{ch}$ qui détermine une valeur efficace, $I_m$, du courant de chauffage de cathode correspondant à un fonctionnement normal du tube.

La figure 2 montre également comment varie la tension de chauffage, $U_{ch}$, lorsque, le tube T étant en fonctionnement normal, l'interrupteur 3 (figure 1) est abaissé. Lorsque l'interrupteur est abaissé les bornes $S_1$ et $S_2$ ne sont plus réunies par un court-circuit tandis que les bornes $S_3$ et $S_4$ le sont à nouveau, comme dans la première étape de chauffage dont il a été question plus haut (entre $t = 0$ et $t = 1$ mn sur la figure 2); il s'en suit une décharge du condensateur $C_2$ jusqu'à une valeur sensiblement égale à la tension de Zener de la diode Z, qui entraîne donc un retour à un "préchauffage" de la cathode du tube T.

La figure 3 montre comment varie la tension de commande, U, lorsque, le tube T étant en fonctionnement normal (relais $G_1$ en position de travail, relais $G_2$ en position de repos, tensions correctes fournies par la source de tensions 1), brusquement au temps $t_1$ les tensions délivrées par la source 1 chutent.

Du fait de la constante de temps de 5 secondes à la mise hors tension du relais $G_1$ les bornes $S_1$ et $S_2$ restent court-circuitées du temps $t_1$ au temps $t_2 = t_1 + 55$. Pendant cet intervalle de temps le condensateur $C_2$ se décharge avec une constante de temps sensiblement égale à $C_2 R_7$; la tension U chute de ce fait relativement lentement pendant cet intervalle de temps. Si les tensions fournies par la source 1 redeviennent normales pendant l'intervalle de temps $t_1$ $t_2$, par exemple au moment où la tension de commande ne vaut plus que 6,5 volts, cette tension U remonte, comme indiqué sur la courbe en traits interrompus de la figure 3 et la tension de chauffage $U_{ch}$ remonte pratiquement instantanément à une valeur permettant une reprise de l'exploitation. Il s'en suit que le fonctionnement normal du tube reprend très rapidement sans qu'il soit besoin de passer par la première étape de chauffage correspondant sur la figure 2 à la partie de la courbe comprise entre $t = 0$ et $t = 1$ mn. Ceci n'est bien sûr possible que du fait de l'inertie thermique présentée par le tube T qui fait qu'après avoir été portée à sa température normale de fonctionnement, la cathode du tube T reste encore, en l'absence de tension de chauffage, au moins 5 secondes à une température supérieure à sa température de "préchauffage".

L'invention n'est pas limitée à l'exemple décrit; c'est ainsi que, par exemple différents autres circuits peuvent être envisagés pour fournir les signaux de commande des thyristors de puissance; en particulier un seul thyristor de puissance peut être utilisé au lieu des deux thyristors de la figure 1 mais alors le courant de chauffage n'est appliqué que pendant une alternance sur deux de la tension de 380 V délivrée par la source 1; dans le cas de plusieurs tubes à chauffer il est possible d'utiliser la même tension U (figure 1) pour commander les chauffages de ces tubes; de même les relais $G_1$ et $G_2$ peuvent être remplacés par des dispositifs électroniques. De plus le nombre des étapes successives par lesquelles passe la tension de chauffage lorsqu'elle est appliquée et lorsqu'elle est coupée peut être pris supérieur à deux.

L'invention peut être appliquée, d'une manière générale, à tous les émetteurs, existants ou à fabriquer, comportant un tube électronique de puissance.

## Revendications

1. Dispositif de chauffage de cathode pour tube électronique de puissance, comportant un circuit d'alimentation fournissant le courant de chauffage de la cathode, des moyens de commande de ce circuit d'alimentation pour commander une augmentation prédéterminée de ce courant jusqu'à une valeur $I_0$ pour un préchauffage de tube puis, pour un fonctionnement normal du tube, jusqu'à une valeur $I_m$ ($I_m$: courant de chauffage lorsque la cathode a atteint sa température pour un fonctionnement normal du tube; $I_0$: courant de valeur donnée, inférieur à $I_m$), caractérisé en ce qu'il comporte un circuit interrupteur statique, connu en soi, pour couper l'alimentation, ce circuit interrupteur étant placé entre la cathode (K) du tube (T) et le circuit d'alimentation, en ce que les moyens de commande (2, $d_3$—$d_7$, $R_3$—$R_7$, $C_1$,$C_2$,$T_r$, $G_1$,$G_2$,Z) commandent de

manière connue en soi, à une fréquence F donnée, l'ouverture du circuit interrupteur, et en ce que les moyens de commande comportent: un premier circuit (2) pour commander la durée d'une ouverture, et un second circuit $d_3$—$d_7$, $R_3$—$R_7$,$C_2$,$T_r$,$G_1$,$G_2$,Z) pour fournir au premier circuit un signal de commande U dont la valeur varie de 0 à $U_0$ avec une première pente prédéterminée et de $U_0$ à $U_m$ avec une seconde pente prédéterminée distincte de la première pente ($U_0$ et $U_m$ étant les valeurs du signal de commande qui déterminent les courants $I_0$ et $I_m$).

2. Dispositif de chauffage de cathode selon la revendication 1, caractérisé en ce que, le circuit d'alimentation (1) étant un circuit qui fournit un courant alternatif à la fréquence F', la fréquence F est choisie égale à F' et le circuit interrupteur est un dispositif comportant n thyristors ($D_1 D_2$) (n entier positif), en ce que les moyens de commande sont destinés à fournir, à la fréquence F, des signaux de déblocage aux électrodes de commande des n thyristors, et en ce que, pour cela, leur premier circuit est un circuit de commande de thyristors recevant de l'alimentation une tension de synchronisation et leur second circuit un circuit de commande en tension.

3. Dispositif de chauffage de cathode selon la revendication 2, caractérisé en ce que, le circuit de commande en tension comporte un premier ($C_2$ $R_5$) et un second ($C_2$ $R_5 + R_6$) circuit à constante de temps pour fournir le signal U et un dispositif de commutation temporisé ($G_1$, $G_2$, 3) pour mettre en service l'un ou l'autre des circuits à constante de temps.

4. Dispositif de chauffage de cathode selon la revendication 3, caractérisé en ce que, lorsque la cathode du tube doit être chauffée, le dispositif de commutation temporisé met en service le premier circuit à constante de temps puis, au bout d'un temps T préréglé, met en service le second circuit à constante de temps à la place du premier circuit à constante de temps.

5. Dispositif de chauffage de cathode selon la revendication 4, caractérisé en ce que, lorsque, le tube étant en fonctionnement normal, le circuit d'alimentation est brusquement défaillant, le dispositif de commutation temporisé met hors-service le second circuit à constante de temps au bout d'un temps T' préréglé.

6. Emetteur équipé d'un tube de puissance, caractérisé en ce que, le chauffage de la cathode de ce tube, il comporte un dispositif de chauffage de cathode selon l'une des revendications précédentes.

## Patentansprüche

1. Vorrichtung zur Kathodenheizung einer Leistungsröhre mit einer Spreisungsschaltung, die den Heizstrom für die Kathode liefert, und Steuermitteln für die Speisungsschaltung, um eine vorbestimmte Zunahme im Strom zu steuern bis zu einem Wert $I_o$ zur Vorheizung der Röhre, dann für die normale Funktion der Röhre bis zu einem Wert $I_m$ ($I_m$: Heizstrom wenn die Kathode ihre Temperatur für normalen Betrieb erreicht hat; $I_o$: Strom von gegebenem Wert, niedriger als $I_m$), dadurch gekennzeichnet, dass sie eine statische Unterbrecherschaltung enthält, die an sich bekannt ist, und zur Unterbrechung der Speisung dient, wobei die Unterbrecherschaltung zwischen der Kathode (K) der Röhre (T) und der Speisungsschaltung angeordnet ist; dass die Steuermittel (2, $d_3$—$d_7$, $R_3$—$R_7$, $C_1$,$C_2$,$T_r$, $G_1$,$G_2$,Z) in bekannter Weise, bei einer gegebenen Frequenz F das Öffnen des Schaltungsunterbrechers steuern; und dass die Steuermittel umfassen: eine erste Schaltung (2) zum Steuern der Dauer des Öffnens und eine zweite Schaltung ($d_3$—$d_7$,$R_3$—$R_7$,$C_2$,$T_r$,$G_1$, $G_2$, Z), um der ersten Schaltung ein Steuersignal U zu geben, dessen Wert zwischen O und $U_o$ bei einer ersten vorgegebenen Steigung schwankt und zwischen $U_o$ und $U_m$ bei einer zweiter vorgegebenen Steigung, die sich von der ersten vorgegebenen Steigung unterscheidet ($U_o$ und $U_m$ sind Werte des Steuersignals, das den Strom $I_o$ und den Strom $I_m$ bestimmt).

2. Vorrichtung zur Kathodenheizung gemäß Anspruch 1, dadurch gekennzeichnet dass, bei Ausbildung der Speisungsschaltung als eine Schaltung, die einen Wechselstrom mit der Frequenz F' abgibt, die Frequenz F gleich F' gewählt wird und die Unterbrecherschaltung eine Vorrichtung ist, die n Thyristoren ($D_1$$D_2$) (n vollständig positiv) enthält; dass die Steuermittel die Aufgabe haben, bei einer Frequenz F signale zum Öffnen der Steuerelektroden von n Thyristoren zu geben, und dass irhre erste Schaltung eine Steuerschaltung für die Thyristoren ist, die von der Speisung eine Synchronisationsspannung erhalten und ihre zweite Schaltung eine Schaltung zur Spannungssteuerung ist.

3. Vorrichtung zur Kathodenheizung gemäß Anspruch 2, dadurch gekennzeichnet dass die Schaltung zur Spannungssteuerung eine erste ($C_2$$R_5$) und eine zweite($C_2$$R_5$ + $R_6$) konstante Zeitschaltung einschliesst, un ein Signal U zu geben und eine Temporisier—Umschaltevorrichtung, um die eine oder andere der Konstanten Zeitschaltungen in Betrieb zu setzen.

4. Vorrichtung zur Kathodenheizung gemäß Anspruch 3, dadurch gekennzeichnet, dass, wenn die Kathode der Röhre geheizt werden soll, die Temporisier—Unschaltevorrichtung die erste konstante Zeitschaltung in Betrieb setzt, und dann, am Ende der vorbestimmten Zeit T, die zweite konstante Zeitschaltung an stelle der ersten in Betrieb setzt.

5. Vorrichtung zur Kathodenheizung gemäß Anspruch 4, dadurch gekennzeichnet, dass, wenn bei normalem Betrieb der Röhre die Speisungsschaltung plötzlich ausfällt, die Temporisier—Umschaltevorrictung die zweite konstant Zeitschaltung am Ende einer vorbestimmten Zeit T' ausser Betrieb setzt.

6. Sender, Ausgestattet mit einer Leistungsröhre, dadurch gekennzeichnet, dass zum Heizen der Kathode der Röhre eine Vorrichtung zur Kathodenbeheizung gemäß der in den vorstehenden Ansprüchen definierten verwendet wird.

**Claims**

1. Cathode heating device for an electronic power tube, comprising a supply circuit supplying the heating current for the cathode, and control means for the supply circuit to control a predetermined increase in the current up to a value $I_o$ for preheating of the tube, then for the normal operation of the tube up to a value of $I_m$ ($I_m$: heating current when the cathode has reached its temperature for normal operation of the tube; $I_o$: current of a given value, lower than $I_m$), characterized in that it comprises a static interrupter circuit, known per se for cutting the feeding, with said interrupter circuit being placed between the cathode (K) of the tube (T) and the feeding circuit, in that the control means (2, $d_3$—$d_7$, $R_3$—$R_7$, $C_1$,$C_2$,$T_r$, $G_1$,$G_2$,Z) control in a manner known per se, at a given frequency F, the opening of the interrupter circuit, and in that the control means comprise: a first circuit (2) for controlling the duration of an opening, and a second circuit ($d_3$—$d_7$, $R_3$—$R_7$,$C_2$,$T_r$,$G_1$,$G_2$,Z) to give to the first circuit a control signal U, the value of which varies from O to $U_o$ with a first predetermined slope and from $U_o$ to $U_m$ with a second predetermined slope which is different from the first predetermined slope ($U_o$ and $U_m$ being the values of the control signal which determine the currents $I_o$ and $I_m$).

2. Cathode heating device according to claim 1, characterized in that, with supply circuit (1) being a circuit which supplies an alternating current at the frequency F', the frequency F is chosen equal to F' and the interrupter circuit is a device comprising n thyristors ($D_1$$D_2$) (n entirely positive), in that the control means are intended to supply, at the frequency F, signals for unblocking the control electrodes of n thyristors, and in that their first circuit is a control circuit of the thyristors receiving from the supply a synchronization voltage and their second circuit is a control voltage circuit.

3. Cathode heating device according to claim 2, characterized in that the control voltage circuit comprises a first ($C_2$$R_5$) and a second ($C_2$ $R_5$ + $R_6$) constant time circuit to supply the signal U and a temporizer commutation device ($G_1$,$G_2$,3) for putting one or other of the constant time circuits into operation.

4. Cathode heating device according to claim 3, characterized in that, when the cathode of the tube is to be heated, the temporizer commutation device puts into operation the first constant time circuit, then, at the end of a preset time T, puts into operation the second constant time circuit in place of the first constant time circuit.

5. Cathode heating device according to claim 4, characterized in that, when, upon normal operation of the tube, the feeding circuit suddenly fails, the temporizer commutation device puts the second constant time circuit at end of the preset time T' out of operation.

6. Transmitter equipped with a power tube, characterized in that, for heating the cathode of said tube, it comprises a cathode heating device according to one of the preceding claims.

FIG_1

# FIG_2

# FIG_3